# EUROPÄISCHE PATENTSCHRIFT

(11) **EP 1 348 256 B1**
(45) Veröffentlichungstag und Bekanntmachung des Hinweises auf die Patenterteilung: **09.07.2008**
(21) Anmeldenummer: 00988976.7
(22) Anmeldetag: 27.12.2000
(51) Int. Cl.: H03K 17/10, H03K 17/12

(54) **VERFAHREN ZUR DYNAMISCHEN SYMMETRISIERUNG VON REIHEN- UND PARALLELGESCHALTETEN LEISTUNGSHALBLEITERSCHALTERN**
METHOD FOR THE DYNAMIC BALANCING OF SERIES- AND PARALLEL-WIRED POWER SEMICONDUCTOR CIRCUITS
PROCEDE D'EQUILIBRAGE DYNAMIQUE DE CIRCUITS A SEMI-CONDUCTEUR DE PUISSANCE BRANCHES EN SERIE ET EN PARALLELE

(43) Veröffentlichungstag der Anmeldung: 01.10.2003
(73) Patentinhaber: CT-Concept Technologie AG, 2504 Biel (CH)
(72) Erfinder: THALHEIM, Jan, CH-2504 Biel (CH)
(74) Vertreter: Blum, Rudolf Emil
(86) Internationale Anmeldenummer: PCT/IB2000/001968
(87) Internationale Veröffentlichungsnummer: WO 2002/052726

(56) Entgegenhaltungen:
- EP-A- 0 409 384
- EP-A- 0 664 613
- DE-C- 19 838 389
- US-A- 5 566 063

## Beschreibung

### TECHNISCHES GEBIET

Die Erfindung bezieht sich auf das Gebiet der Leistungselektronik. Sie betrifft ein Verfahren zur dynamischen Synchronisierung von Leistungshalbleiterschaltern gemäss Oberbegriff der unabhängigen Ansprüche.

### STAND DER TECHNIK

Ein derartiges Verfahren zur dynamischen Synchronisierung reihengeschalteter Leistungshalbleiterschalter ist in dem Artikel von C. Gerster, "Fast High-power/High-voltage Switch Using Series-connected IGBTs with Active Gatecontrolled Voltage-balancing", Proceedings of 1994 Applied Power Electronics Conference and Exposition, Vol. 1, S. 469-472, IEEE, New York (1994) offenbart. Durch eine zentrale Steuerung wird ein systemweit gültiger Abtastzeitpunkt vorgegeben. In diesem Abtastzeitpunkt werden mittels lokaler Messsysteme die individuellen Kollektor-Emitter Spannungen der IGBTs bestimmt und aus den Istwerten und einem vorgegebenen Referenzwert individuelle Differenzspannungen oder Regelabweichungen ermittelt. In folgenden Schaltzyklen werden die Schaltbefehle für jeden IGBT individuell so verzögert, dass die Regelabweichungen minimiert und die Kollektor-Emitter Spannungen symmetrisiert werden. Problematisch bei diesem Verfahren sind unkontrollierte Zeitabweichungen bei den Signalübertragungen von der zentralen Steuerung zu den lokalen Messystemen. Durch die nicht kompensierten Abweichungen zwischen den Übertragungszeiten sind die maximalen Spannungsanstiegsgeschwindigkeiten begrenzt. Besonders bei der Verwendung preiswerter optischer Verbindungen mit grosser Streuung der Übertragungszeiten muss daher die Schaltgeschwindigkeit unter Inkaufnahme erhöhter dynamischer Verluste reduziert werden. Ein weiteres Problem besteht darin, dass der Zusammenhang zwischen den Regelabweichungen und den erforderlichen Zeitverzögerungen relativ unbestimmt und bestenfalls empirisch bekannt ist und Korrekturen erst in folgenden Schaltzyklen durchgeführt werden können. Zudem ist bei dem Verfahren auch eine Adaption des zentralen Abtastzeitpunkts innerhalb eines begrenzten Zeitfensters notwendig. Ferner wird ein Analog-Digital Wandler benötigt, um die Istwerte in digitalisierter Form der zentralen Steuerung zuzuführen.

### DARSTELLUNG DER ERFINDUNG

Es ist Aufgabe der Erfindung, ein verbessertes Verfahren zur dynamischen Synchronisierung von Leistungshalbleiterschaltern anzugeben, bei dem eine exakte Synchronisierung der individuellen Leistungshalbleiterschalter und eine hohe Schaltgeschwindigkeit der Gesamtanordnung erreichbar sind.

In einem ersten Aspekt besteht die erfindungsgemässe Lösung in einem Verfahren zur dynamischen Symmetrisierung einer Schaltung von Leistungshalbleiterschaltern, wobei jeder Leistungshalbleiterschalter einen ersten Leistungsanschluss oder Kollektor, einen zweiten Leistungsanschluss oder Emitter und mindestens einen Steueranschluss oder ein Gate umfasst, wobei dem Steueranschluss insbesondere von einer zentralen Steuerung ein Schaltbefehl zur Initiierung eines Schaltvorgangs der Schaltung gegeben wird und der Steueranschluss auch in Abhängigkeit von einer Regelabweichung einer Zustandsfunktion des Leistungshalbleiterschalters durch ein individuelles Schaltsignal ansteuerbar ist, wobei ferner die Zustandsfunktion eine zeitabhängige asynchrone Zustandsvariable ist, deren Istwert zu mindestens einem synchronen Abtastzeitpunkt gemessen wird, wobei der synchrone Abtastzeitpunkt aufgrund eines synchronen Ereignisses der Schaltung für jeden Leistungshalbleiterschalter unabhängig bestimmt wird und im gleichen oder in einem der folgenden Schaltzyklen das Schaltsignal zeitlich verschoben oder seine Amplitude variiert wird, so dass die Regelabweichung zwischen dem Istwert und einem vorgebbaren Sollwert verringert wird. Durch die lokale Erzeugung der synchronen Abtastzeitpunkte entfällt die Notwendigkeit, einen zentralen Abtastbefehl zeitlich synchron an die Steuerungen oder Gatetreiber der Leistungshalbleiterschalter zu verteilen. Die Synchronizität ist gleichwohl dadurch garantiert, dass das synchrone Ereignis an jedem Leistungshalbleiterschalter gleiche Werte einer Zustandsvariablen oder einer anderen messbaren Grösse der Schaltung generiert.

In einem Ausführungsbeispiel wird der synchrone Abtastzeitpunkt an jedem Leistungshalbleiterschalter lokal bestimmt. Der synchrone Abtastzeitpunkt kann bestimmt werden, indem ein Bezugszeitpunkt des synchronen Ereignisses um ein den Leistungshalbleiterschaltern gemeinsam vorgebbares Zeitintervall zurück- oder vorverschoben wird. Somit kann der Abtastzeitpunkt an einen flexibel vorgebbaren Zeitpunkt des Schaltvorgangs gelegt werden, wobei das Zeitintervall zeitunkritisch übertragen und lokal in jedem Gatetreiber abgespeichert werden kann.

Ein anderes Ausführungsbeispiel betrifft eine Bestimmung des Sollwert der asynchronen Zustandsvariablen global aus einem Mittelwert der Istwerte einer Mehrzahl oder aller asynchroner Zustandsvariablen. Da der Sollwert nur zur Berechnung der Regelabweichung benötigt wird, ist seine Übertragung im Falle eines globalen Sollwerts nicht zeitkritisch. Alternativ oder ergänzend kann der Sollwert durch Leistungshalbleiterschalter lokal und insbesondere gleich einer Abweichung von einem stationären Wert der asynchronen Zustandsvariablen gewählt werden, welche Abweichung kleiner als 10% eines Erwartungswerts einer Maximalamplitude der asynchronen Zustandsvariablen ist. Vorzugsweise wird für einen Einschaltvorgang einer Reihenschaltung oder für einen Ausschaltvorgang einer Parallelschaltung ein DC-Anteil des Sollwerts und des Istwerts der asynchronen Zustandsvariablen subtrahiert, um die elektronische Verarbeitung zu vereinfachen.

In einem weiteren Ausführungsbeispiel werden zu zwei synchronen Abtastzeitpunkten Istwerte gemessen und aus ihrem Gradienten und einem Gradienten-Sollwert die Regelabweichung bestimmt und es wird eine Amplitude des Schaltsignals, für welches die Regelabweichung einem überhöhten oder erniedrigten Gradienten entspricht, im gleichen oder in einem der folgenden Schaltzyklen verringert oder erhöht. Insbesondere wird ein erster Abtastzeitpunkt in einem geringen Zeitabstand zu einem Bezugszeitpunkt des synchronen Ereignisses gewählt und eine Differenz zwischen den Abtastzeitpunkten durch einen zweiten Abtastzeitpunkt approximiert. Durch die zusätzliche Gradientenregelung kann die Genauigkeit der dynamischen Synchronizität des Schaltverhaltens der Leistungshalbleiterschalter nochmals verbessert werden.

In einem zweiten Aspekt besteht die erfindungsgemässe Lösung in einem Verfahren zur dynamischen Symmetrisierung einer Schaltung von Leistungshalbleiterschaltern, wobei jeder Leistungshalbleiterschalter einen ersten Leistungsanschluss oder Kollektor, einen zweiten Leistungsanschluss oder Emitter und mindestens einen Steueranschluss oder ein Gate umfasst, wobei dem Steueranschluss ein Schaltbefehl zur Initiierung eines Schaltvorgangs der Schaltung gegeben wird und der Steueranschluss in Abhängigkeit von einer Regelabweichung einer Zustandsfunktion des Leistungshalbleiterschalters durch ein individuelles Schaltsignal ansteuerbar ist, wobei ferner die Zustandsfunktion gleich einer Zeitfunktion in Abhängigkeit einer asynchronen Zustandsvariablen des Leistungshalbleiterschalters gewählt wird, für die asynchrone Zustandsvariable mindestens ein den Leistungshalbleiterschaltern gemeinsamer Schwellenwert global vorgegeben wird, für jeden Leistungshalbleiterschalter bei Überschreiten oder Überqueren oder Erreichen des Schwellenwerts ein individueller Zeit-Istwert gemessen wird, durch ein synchrones Ereignis der Schaltung lokal ein Bezugszeitpunkt für den Zeit-Istwert festgelegt wird und im gleichen oder in einem der folgenden Schaltzyklen das Schaltsignal zeitlich verschoben oder in der Amplitude variiert wird, so dass die Regelabweichung zwischen dem Zeit-Istwert und einem vorgebbaren Zeit-Sollwert verringert wird. Durch die Verwendung der inversen Funktion einer zeitabhängigen asynchronen Zustandsvariablen kann aus dem Überschreiten des globalen Schwellenwerts auf das Mass der Asynchronizität der Leistungshalbleiterschalter geschlossen und diese an jedem Leistungshalbleiterschalter individuell korrigiert werden.

In zugehörigen Ausführungsbeispielen wird der Zeit-Sollwert global aus einem Maximum der Zeit-Istwerte bestimmt oder lokal gewählt. Wiederum ist die Übertragung eines globalen Zeit-Sollwerts zeitunkritisch. Die Regelabweichung kann aus einer Differenz zwischen dem Zeit-Istwert und dem Zeit-Sollwert lokal bestimmt werden oder der Bezugszeitpunkt kann nahe beim Zeit-Sollwert gewählt und die Regelabweichung durch den Zeit-Istwert approximiert werden und/oder das Schaltsignal kann initial verzögert und/oder seine Amplitude initial reduziert werden. Durch die letztgenannte Massnahme können asynchron schaltende Leistungshalbleiterschalter sowohl zeitlich verzögert als auch verfrüht eingeschaltet werden als auch ihre Amplitude erhöht oder erniedrigt werden. Schliesslich können bei zwei Schwellenwerten der asynchronen Zustandsvariablen Zeit-Istwerte gemessen werden, aus ihrem Gradienten und einem Gradienten-Sollwert die Regelabweichung bestimmt werden und eine Amplitude des Schaltsignals, für welches die Regelabweichung einem überhöhten oder erniedrigten Gradienten entspricht, im gleichen oder in einem folgenden Schaltzyklus verringert oder erhöht werden.

Beispiele für asynchrone Zustandsvariablen sind bei einer Serieschaltung eine Kollektor-Emitter oder Anoden-Kathoden Spannung oder ein Kollektor-Emitter oder Anoden-Kathoden Spannungsgradient oder bei einer Parallelschaltung ein Kollektor- oder Anodenstrom oder ein Kollektor- oder Anodenstromgradient. Beispiele für eine synchrone Zustandsvariable sind bei einer Serieschaltung ein Kollektor- oder Anodenstrom oder ein Kollektorstrom- oder Anodenstromgradient oder bei einer Parallelschaltung eine Kollektor-Emitter oder Anoden-Kathoden Spannung oder ein Kollektor-Emitter oder Anoden-Kathoden Spannungsgradient.

Beispiele für ein synchrones Ereignis sind das Überschreiten oder Überqueren oder Erreichen eines vorgebbaren Schwellenwerts einer synchronen Zustandsvariablen oder gegenläufige Amplitudenänderungen asynchroner Zustandsvariablen unterschiedlicher Leistungshalbleiterschalter. Insbesondere wird das synchrone Ereignis zu Beginn des Schaltvorgangs gewählt, indem eine Abweichung des Schwellenwerts von einem stationären Wert der synchronen Zustandsvariablen kleiner als 10% eines Erwartungswerts einer Maximalamplitude der synchronen Zustandsvariablen gewählt wird.

In weiteren Ausführungsbeispielen wird für einen Ausschaltvorgang einer Parallelschaltung das synchrone Ereignis näherungsweise dadurch definiert, dass in einer Phase A, in welcher die Freilaufdiode in einem leitfähigen Zustand ist, die asynchrone Zustandsvariable einen vorgebbaren Schwellenwert unterschreitet oder überquert oder erreicht. Oder es wird für einen Einschaltvorgang einer Serieschaltung das synchrone Ereignis näherungsweise dadurch definiert, dass in einer Phase B, in welcher die Freilaufdiode in einem Sperrzustand ist, die asynchrone Zustandsvariable einen vorgebbaren Schwellenwert unterschreitet oder überquert oder erreicht. Alternativ kann das synchrone Ereignis durch einen Wechsel zwischen einer Phase A, in welcher eine in Serie zur Schaltung angeordnete Freilaufdiode in einem leitfähigen Zustand ist, und einer Phase B, in welcher die Freilaufdiode in einem Sperrzustand ist, definiert werden. Der Wechsel kann von A nach B oder von B nach A erfolgen. Man kann auch für einen Ausschaltvorgang einer Parallelschaltung einen Bezugszeitpunkt des synchronen Ereignisses gleich einem Zeitpunkt wählen, zu dem eine Kollektor-Emitter oder Anoden-Kathoden Spannung einen Schwellenwert überschreitet und ein Kollektor-Emitter oder Anoden-Kathoden Spannungsgradient einen Schwellenwert, insbesondere Null, unterschreitet. Oder man kann für einen Einschaltvorgang einer Serieschaltung einen Bezugszeitpunkt des synchronen Ereignisses gleich einem Zeitpunkt wählen, zu dem eine Kollektor-Emitter oder Anoden-Kathoden Spannung einen Schwellenwert unterschreitet. Insbesondere kann der Schwellenwert kleiner als ein Erwartungswert der Kollektor-Emitter oder Anoden-Kathoden Spannung am Ende der Phase A gewählt werden.

Weitere Ausführungen, Vorteile und Anwendungen der Erfindung ergeben sich aus den abhängigen Ansprüchen sowie aus der nun folgenden Beschreibung anhand der Figuren.

### KURZE BESCHREIBUNG DER ZEICHNUNGEN

Es zeigen
- Fig. 1a: schematisch eine Parallelschaltung mit beispielhaft 2 Leistungshalbleiterschaltern sowie für die Parallelschaltung einen Einschaltvorgang (Fig. 1b) und einen Ausschaltvorgang (Fig 1c);
- Fig. 2a: schematisch eine Serieschaltung mit beispielhaft 2 Leistungshalbleiterschaltern sowie für die Serieschaltung einen Einschaltvorgang (Fig. 2b) und einen Ausschaltvorgang (Fig 2c);
- Fig. 3: ein Blockdiagramm zur Funktionsweise eines erfindungsgemässen Gatetreibers; und
- Fig. 4a: eine Serieschaltung und Fig. 4b eine Parallelschaltung jeweils mit einer in Serie angeordneten Freilaufdiode.

In den Figuren sind gleiche Teile mit gleichen Bezugszeichen versehen.

### WEGE ZUR AUSFÜHRUNG DER ERFINDUNG

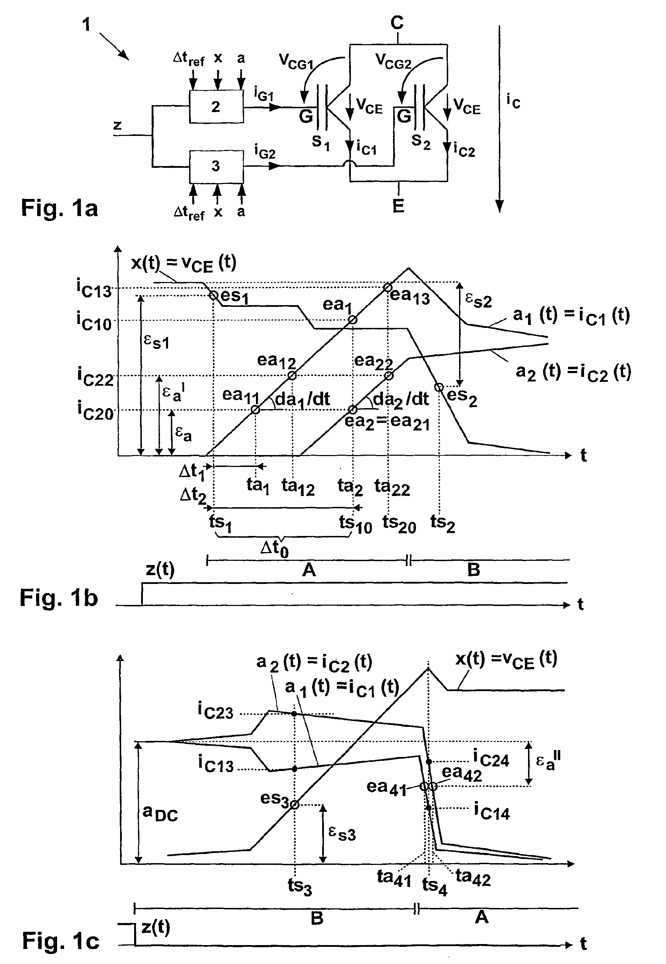

In Fig. 1a werden zwei parallele Leistungshalbleiterschalter S₁ und S₂ durch jeweils einen zugehörigen Gate-Treiber 2, 3 angesteuert. Jeder Gate-Treiber 2, 3 erhält einen zentralen Schaltbefehl z sowie zusätzlich einen Zeitintervall-Sollwert Δt_{ref} sowie Istwerte und Sollwerte mindestens eines synchronen Ereignisses oder einer synchronen Variablen x und mindestens einer asynchronen Variablen a. Typischerweise werden die Istwerte x und a lokal beim Leistungshalbleiterschalter S₁ oder S₂ gemessen. Im Gate-Treiber 2, 3 wird aufgrund der Eingabewerte z, Δt_{ref}, x und a ein Stellsignal oder Schaltsignal, nämlich ein Gatestrom i_{G1}, i_{G2} oder eine Gatespannung v_{CG1}, v_{CG2} oder ein Zeitintegral des Gatestroms i_{G1}, i_{G2}, erzeugt und an den Steueranschluss oder das Gate G des Leistungshalbleiterschalters S₁ oder S₂ geliefert. Die Kollektor-Emitter Spannung v_{CE} (gegebenenfalls auch Anoden-Kathoden Spannung genannt) ist in der Parallelschaltung 1 über beiden Leistungshalbleiterschaltern S₁ und S₂ identisch und stellt somit eine synchrone Zustandsvariable dar. Die Kollektorströme i_{C1}, i_{C2} (gegebenenfalls auch Anodenströme genannt) können jedoch aufgrund des unterschiedlichen Schaltverhaltens der Leistungshalbleiterschalter S₁ und S₂ voneinander abweichen und bedürfen der dynamischen Synchronisierung.

Fig. 1b zeigt für einen Einschaltvorgang typische Zeitverläufe des Schaltbefehls z(t), der synchronen Zustandsfunktion oder (zeitabhängigen) Zustandsvariablen x(t)=v_{CE}(t) und der asynchronen Zustandsfunktionen oder (zeitabhängigen) Zustandsvariablen a₁(t)=i_{C1}(t) und a₂(t)= i_{C2}(t). Im gezeigten Beispiel eilt oder eilen a₁(t) vor und/oder a₂(t) nach. Messtechnisch werden Kollektorströme i_{C1}(t), i_{C2}(t) dadurch erfasst, dass der Spannungsabfall über einer Induktivität im Leistungskreis, beispielsweise der Emitterinduktivtät, integriert wird. Vorzugsweise wird ein Beginn des Integrationsintervalls in der Nähe des Beginns einer Haupttransienten des zu messenden Kollektorstroms i_{C1}(t), i_{C2}(t) gewählt. Dadurch kann eine offsetbedingte Drift im integrierten Signal minimiert werden. Im folgenden werden vier erfindungsgemässe Verfahren zur dynamischen Symmetrisierung von a₁(t) und a₂(t) angegeben.

In einem ersten Fall wird ein synchrones Ereignis es₁ durch Vorgabe eines Schwellenwerts εₛ₁ für die synchrone Zustandsvariable x(t) definiert. Das Erreichen, hier Unterschreiten, des Schwellenwerts εₛ₁ wird an jedem Leistungshalbleiterschalter S₁, S₂ oder u. U. für eine Gruppe räumlich benachbarter Leistungshalbleiterschalter lokal gemessen und der zugehörige Bezugszeitpunkt ts₁ festgehalten. Relativ zum Bezugszeitpunkt ts₁ wird durch Addition eines Zeitintervalls Δt₀ ein Abtastzeitpunkt ts₁₀ generiert, zu dem für die asynchronen Ereignisse ea₁ und ea₂ auf den Kurvenzügen der asynchronen Zustandsvariablen a₁(t) und a₂(t) die Istwerte i_{C10} und i_{C20} gemessen werden. In einem nicht näher dargestellten Regelkreis werden die Istwerte i_{C10} und i_{C20} mit vorgebbaren Sollwerten verglichen, eine Regelabweichung bestimmt und die individuellen Schaltsignale i_{C1} und i_{C2} so zeitlich verzögert oder beschleunigt und/oder amplitudenmässig angepasst, dass im gleichen Schaltzyklus oder in folgenden Schaltzyklen die Regelabweichung verringert wird. Dadurch gelangen die asynchronen Zustandsvariablen a₁(t) und a₂(t) zumindest für einen wesentlichen Teil des Schaltvorgangs weitgehend in Übereinstimmung, d. h. die asynchronen Zustandsvariablen a₁(t) und a₂(t) werden synchron, alle Leistungshalbleiterschalter S₁, S₂ tragen im wesentlichen den gleichen Kollektorstrom i_{C1}(t)≈i_{C2}(t) und die gleiche thermische Last. Die Schaltzeiten können unter Beibehaltung einer grossen Synchronizität extrem kurz gewählt werden, nämlich im Bereich von unter 1 µs, bevorzugt unter 500 ns, besonders bevorzugt unter 100 ns, und die dynamischen Schaltverluste werden entsprechend minimiert.

In einem zweiten Fall kann für mindestens eine der asynchronen Zustandsvariablen a₁(t) und a₂(t) ein Gradienten-Istwert gemessen, mit einem Gradienten-Sollwert verglichen und eine zugehörige Regelabweichung im gleichen oder einem folgenden Schaltzyklus verringert werden. Hierfür werden mindestens ein zweiter Abtastzeitpunkt ts₂₀ generiert, für die zugehörigen asynchronen Ereignisse ea₂₂ und ea₁₃ die Istwerte i_{C22} und i_{C13} bestimmt und aus jeweils zwei zusammengehörenden Istwerten i_{C10}, i_{C13}; i_{C20}, i_{C22} und der Differenz der Abtastzeitpunkte ts₂₀-ts₁₀ Gradienten-Istwerte da₂/dt und/oder da₁/dt gebildet.

In einem dritten Fall wird ein gemeinsamer oder globaler Schwellenwert εₐ für die asynchronen Zustandsvariablen a₁(t) und a₂(t) vorgegeben und es werden für die asynchronen Ereignisse ea₂₁ und ea₁₁ die Zeit-Istwerte ta₁ und ta₂ bei Überschreiten des Schwellenwerts εₐ gemessen. Als Bezugszeitpunkt wird wieder ts₁ verwendet und ta₁ durch die Differenz Δt₁=ta₁-ts₁ sowie ta₂ durch die Differenz Δt₂=ta₂-ts₁ ausgedrückt. Eine Regelabweichung wird vorzugsweise proportional zur Differenz der Zeit-Istwerte ta₂-ta₁=Δt₂-Δt₁ gebildet und durch Variation der individuellen Schaltsignale minimiert.

In einem vierten Fall werden zwei Schwellenwerte εₐ und εₐ' vorgegeben, für die zugehörigen asynchronen Ereignisse ea₁₁, ea₁₂, ea₂₁ und ea₂₂ die Zeit-Istwerte ta₁, ta₁₂, ta₂ und ta₂₂ gemessen, aus den Differenzen der Schwellenwerte εₐ'-εₐ und der zueinander gehörenden Zeit-Istwerte ta₁₂-ta₁ und ta₂₂-ta₂ Gradienten-Istwerte da₂/dt und da₁/dt gebildet und durch Vergleich mit Gradienten-Sollwerten die Regelabweichung bestimmt.

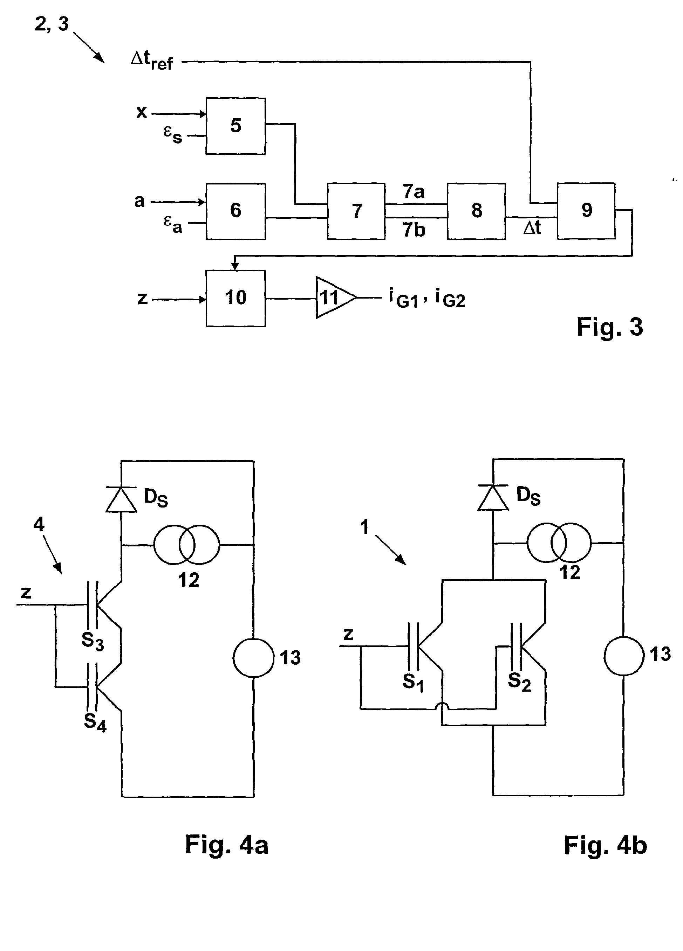

In den oben genannten Fällen werden der Bezugszeitpunkt ts₁ des synchronen Ereignisses es₁, die Abtastzeitpunkte ts₁₀ und ts₂₀ und asynchrone Zeit-Istwerte ta₁; ta₁₂, ta₂, ta₂₂ vorzugsweise in eine Phase A des Schaltvorgangs gelegt, in welcher eine in Serie zur Schaltung 1 angeordnete Freilaufdiode Dₛ (Fig. 4b) in einem leitfähigen Zustand ist. Der Bezugszeitpunkt t_{S1} in Phase A kann auch durch einen Bezugszeitpunkt ts₂ eines zweiten synchronen Ereignisses es₂ in der Phase B ersetzt werden, in welcher die Freilaufdiode Dₛ in einem Sperrzustand ist. Das zweite synchrone Ereignis es₂ wird dadurch definiert, dass die synchrone Zustandsvariable x(t) einen Schwellenwert εₛ₂ über- oder unterschreitet, der bezüglich eines vor (wie dargestellt) oder nach dem Schaltvorgang stationären Werts der synchronen Zustandsvariablen x(t) definiert wird.

Fig. 1c zeigt einen typischen Ausschaltvorgang für die Parallelschaltung 1. Beispielhaft seien drei Fälle diskutiert. Ein Bezugszeitpunkt und zugleich Abtastzeitpunkt ts₃ kann durch Vorgabe eines Schwellenwerts εₛ₃ für ein synchrones Ereignis es₃ der synchronen Zustandsfunktion x(t)=v_{CE}(t) in der Phase B vorgegeben werden. Die Istwerte i_{C13}, i_{C23} der asynchronen Zustandsfunktionen a₁(t)=i_{C1}(t) und a₂(t)=i_{C2}(t) werden mit einem Sollwert, z. B. dem stationären Wert vor Initiierung des Schaltvorgangs durch den Schaltbefehl z(t), verglichen und die zugehörigen Regelabweichungen minimiert, um eine Symmetrisierung der Leistungshalbleiterschalter S₁ und S₂ während des Abschaltvorgangs zu erreichen. Alternativ kann ein Bezugszeitpunkt und zugleich Abtastzeitpunkt ts₄ durch das synchrone Ereignis einer Ablösung der Phase B durch die Phase A definiert werden. Wiederum stellt die Differenz zwischen den asynchronen Istwerten i_{C14} und i_{C24} ein Mass für die Regelabweichung und Asynchronizität dar und soll minimiert werden. In einem dritten Ausführungsbeispiel wird ein Schwellenwert εₐ" unterhalb des stationären Werts a_{DC} vor dem Ausschalten vorgegeben, es werden für die in der Phase B gelegenen asynchronen Ereignisse ea₄₁ und ea₄₂ die Zeit-Istwerte ta₄₁ und ta₄₂ bezüglich eines Bezugszeitpunkts ts₃ oder ts₄ bestimmt und durch Vergleich mit einem Sollwert die Regelabweichungen berechnet.

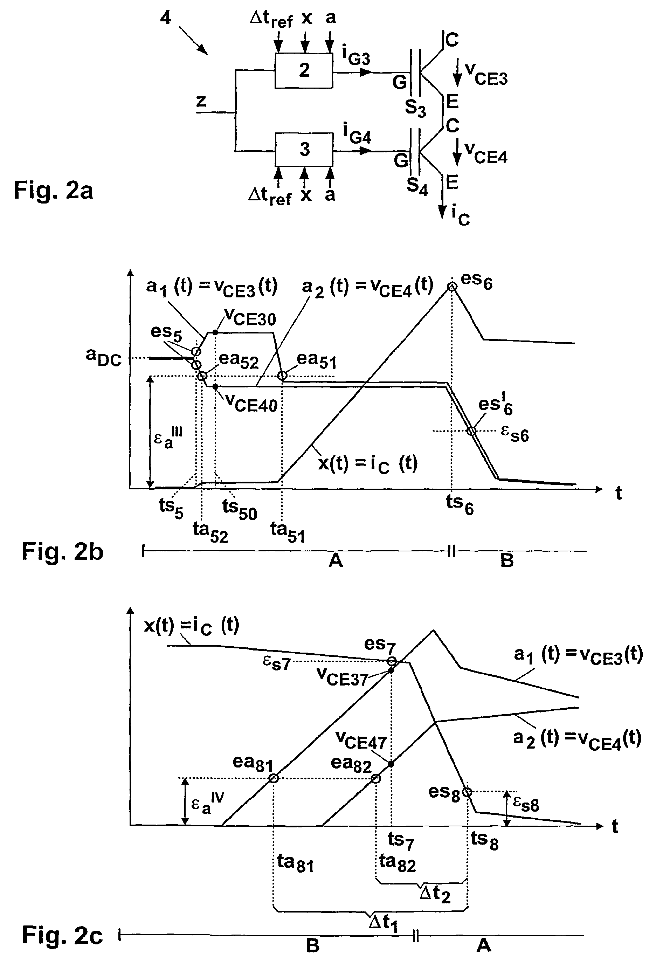

Fig. 2a zeigt den Fall einer Serieschaltung 4 von beispielhaft zwei Leistungshalbleiterschaltern S₃ und S₄ mit individuellen oder asynchronen Kollektor-Emitter Spannungen v_{CE3} und v_{CE4} (gegebenenfalls Anoden-Kathoden Spannungen genannt) und einem synchronen Kollektorstrom i_{c} (gegebenenfalls Anodenstrom genannt) sowie den Gateströmen i_{G3} und i_{G4}. Fig. 2b zeigt den Einschaltvorgang. Ein Bezugszeitpunkt kann prinzipiell wie zuvor durch ein synchrones Ereignis auf der synchronen Zustandsfunktion x(t)=i_{c}(t) definiert werden (nicht dargestellt). Ein quasi synchrones Ereignis es₅ tritt zum Bezugszeitpunkt ts₅ auf, wenn mindestens zwei asynchrone Zustandsvariablen a₁(t)=v_{CE3}(t) und a₂(t)=v_{CE4}(t) messbare gegenläufige Änderungen erfahren. Der Abtastzeitpunkt ts₅₀ wird in die Phase A gelegt, so dass bei asynchronem Schalten unterschiedliche Istwerte V_{CE30} und V_{CE40} der asynchronen Zustandsvariablen gemessen werden können und aus diesen eine Regelabweichung abgeleitet werden kann. Alternativ zur Wahl eines Abtastzeitpunkts ts₅₀ können auch ein globaler Schwellenwert εₐ"' für die asynchronen Zustandsvariablen a₁(t) und a₂(t) vorgegeben werden und aus den zugehörigen Istwerten ea₅₁ und ea₅₂ die Regelabweichungen bestimmt werden. Als Bezugszeitpunkt ts₆ eines synchronen Ereignisses es₆ kann auch der Ablösezeitpunkt zwischen den Phasen A und B verwendet werden. Ein Bezugszeitpunkt eines synchronen Ereignisses es₆' in der Phase B kann auch dadurch gewählt werden, dass eine Kollektor-Emitter Spannung v_{ce} einen Schwellenwert εₛ₆ unterschreitet, der insbesondere kleiner als ein Erwartungswert der Kollektor-Emitter Spannung v_{ce} am Ende der Phase A gewählt wird.

Fig. 2c zeigt den Ausschaltvorgang. Beispielhaft sind dargestellt eine Erfassung asynchroner Istwerte v_{CE37} und V_{CE47} zu einem synchronen Abtastzeitpunkt ts₇ typischerweise in der Phase B. Alternativ kann in der Phase A ein globaler Schwellenwert εₛ₈ zur Festlegung eines Bezugszeitpunkts ts₈ auf der synchronen Zustandsfunktion x(t)=i_{c}(t) vorgegeben werden und mit Hilfe eines gemeinsamen Schwellenwerts εₐ^{iv} für die asynchronen Zustandsfunktionen a₁(t)=v_{CE3}(t) und a₂(t)=V_{CE4}(t) die asynchronen Zeit-Istwerte ta₈₁ und ta₈₂ bestimmt werden.

Die Berechnung von Regelabweichungen aus den Ist- und Sollwerten erfolgt wie oben beschrieben. Generell gilt, dass das Schaltsignal, für welches die Regelabweichung einem Vorauseilen eines Istwerts gegenüber einem Sollwert oder eines Zeit-Istwerts gegenüber einem Zeit-Sollwert entspricht, zeitlich verzögert oder in der Amplitude reduziert wird oder dass das Schaltsignal, für welches die Regelabweichung einem Nacheilen eines Istwerts gegenüber einem Sollwert oder eines Zeit-Istwerts gegenüber einem Zeit-Sollwert entspricht, zeitlich vorverschoben oder in der Amplitude erhöht wird.

Fig. 3 zeigt ein Blockschaltbild zur erfindungsgemässen Funktionsweise eines Gate-Treibers 2, 3. 5 stellt einen Schwellwertschalter für mindestens eine synchrone Zustandsvariable x(t) und mindestens einen zugehörigen Schwellenwert εₛ (εₛ₁, εₛ₂, εₛ₃, εₛ₅, εₛ₆, εₛ₇, εₛ₈) dar. 6 stellt einen Schwellwertschalter für asynchrone Zustandsvariablen a oder a(t) (a₁(t), a₂(t)) und mindestens einen zugehörigen Schwellenwert εₐ (εₐ, εₐ', εₐ", εₐ"', εₐ^{iv}) dar. Zur Notation sei angemerkt, dass allgemein Istwerte und Sollwerte für die asynchronen Zustandsfunktionen a(t) als aᵢ und aₛ und für die synchronen Zustandsfunktionen x(t) als xᵢ und xₛ, die synchronen Ereignisse es₁...es₃, es₅...es₈ als eₛ, die asynchronen Ereignisse ea₁, ea₂, ea₁₁, ea₁₂, ea₁₃, ea₂₁, ea₂₂, ea₄₁, ea₄₂, ea₅₁, ea₅₂, ea₈₁, ea₈₂ als eₐ, die Bezugszeitpunkte ts₁..ts₈ als ts, die Abtastzeitpunkte ts₁₀, ts₂₀, ts₃, ts₄, ts₅₀ als tsⱼ, die asynchronen Zeit-Istwerte ta₁, ta₁₂, ta₂, ta₂₂, ta₄₁, ta₄₂, ta₅₁, ta₅₂, ta₈₁, ta₈₂ als taᵢ und die zugehörigen Sollwerte als taₛ bezeichnet werden können. Ferner bezeichnet t(a) eine Zeitfunktion in Abhängigkeit einer asynchronen Zustandsvariablen. Die Uhr 7 startet bei dem ersten Signal x oder a ein Startsignal 7a und bei dem zweiten Signal a oder x ein Stoppsignal 7b für den Zähler 8. Dieser generiert einen Zeitintervall-Istwert Δt, der in einem Differenzverstärker 9 mit dem Zeitintervall-Sollwert Δt_{ref} verglichen wird. Der Vergleichs- oder Differenzwert wird zusammen mit dem Schaltbefehl z für die Schaltung 1, 4 zur Ansteuerung einer steuerbaren Verzögerungsschaltung 10 zugeführt, die ihrerseits einen Gatestromgenerator 11 zur Erzeugung des gewünschten Gatestroms i_{G1} oder i_{G2} oder allgemein des individuellen Schaltsignals ansteuert.

Fig. 4a zeigt für eine Serieschaltung 4 und Fig. 4b für eine Parallelschaltung 1 eine zur Leistungshalbleiterschalter-Schaltung 1, 4 in Serie angeordnete Freilaufdiode Dₛ sowie den Leistungskreis mit einer Spannungsquelle 13 und einer Last 12.

Die Schaltung 1, 4 kann Bestandteil eines Schaltermoduls, insbesondere eines Halbbrückenzweigs eines Wechselrichters, für Traktion, Hochspannungsgleichstromübertragung, Radiosender, induktives Erwärmen oder induktives Schweissen sein. Die Schaltung 1, 4 kann eine Parallelschaltung 4, eine Reihenschaltung 1 oder eine Kombination von Parallel- und Reihenschaltungen 4, 1 sein. Bei den Leistungshalbleiterschaltern S₁-S₄ handelt es sich z. B. um BJTs, IGBTs, MOSFETs, Thyristoren, GTOs, MCTs oder Kombinationen solcher Bauelemente.

Insgesamt wird durch die Erfindung eine Synchronisierung des dynamischen Schaltverhaltens von Leistungshalbleiterschaltern unabhängig von einem zentralen Schaltbefehl z dadurch erreicht, dass asynchrone Ereignisse der Leistungshalbleiterschalter S₁-S₄ unter Bezugnahme auf synchrone Ereignisse der Schaltung 1, 4 durch lokale Messsysteme detektiert und weitgehend synchronisiert werden. Im Prinzip kann der Schaltbefehl z auch mindestens teilweise dezentral erteilt werden. Beispielsweise kann mindestens ein erster Leistungshalbleiterschalter S₁ den Schaltbefehl z von einer zentralen Steuerung erhalten und an zweite Leistungshalbleiterschalter S₂-S₄ einen lokalen Einschaltbefehl weitergeben. Die anderen Leistungshalbleiterschalter S₂-S₄ können aber auch selber den Schaltvorgang erkennen und lokal Schaltbefehle erzeugen, z. B. aufgrund der Beobachtung von Änderungen ihrer synchronen und/oder asynchronen Zustandsvariablen x(t) und/oder a(t).

## Patentansprüche

1. Verfahren zur dynamischen Symmetrisierung einer Schaltung (1, 4) von Leistungshalbleiterschaltern (S₁-S₄), wobei jeder Leistungshalbleiterschalter (S₁-S₄) einen ersten Leistungsanschluss oder Kollektor (C), einen zweiten Leistungsanschluss oder Emitter (E) und mindestens einen Steueranschluss oder ein Gate (G) umfasst, wobei dem Steueranschluss (G) ein Schaltbefehl (z) zur Initiierung eines Schaltvorgangs der Schaltung (1, 4) gegeben wird und der Steueranschluss (G) in Abhängigkeit von einer Regelabweichung einer Zustandsfunktion des Leistungshalbleiterschalters (S₁-S₄) durch ein individuelles Schaltsignal ansteuerbar ist, **dadurch gekennzeichnet, dass**
a) die Zustandsfunktion eine zeitabhängige asynchrone Zustandsvariable (a(t)) ist, deren Istwert (aᵢ) zu mindestens einem synchronen Abtastzeitpunkt (tsⱼ) gemessen wird, wobei der synchrone Abtastzeitpunkt (tsⱼ) aufgrund eines synchronen Ereignisses (eₛ) der Schaltung (1, 4) für jeden Leistungshalbleiterschalter (S₁-S₄) unabhängig bestimmt wird und
b) im gleichen oder in einem der folgenden Schaltzyklen das Schaltsignal (i_{G1}, i_{G2}) zeitlich verschoben oder seine Amplitude variiert wird, so dass die Regelabweichung zwischen dem Istwert (aᵢ) und einem vorgebbaren Sollwert (aₛ) verringert wird.

2. Verfahren nach Anspruch 1, **dadurch gekennzeichnet, dass**
a) der synchrone Abtastzeitpunkt (tsⱼ) an jedem Leistungshalbleiterschalter (S₁-S₄) lokal bestimmt wird und/oder
b) der synchrone Abtastzeitpunkt (tsⱼ) bestimmt wird, indem ein Bezugszeitpunkt (ts) des synchronen Ereignisses (eₛ) um ein den Leistungshalbleiterschaltern (S₁-S₄) gemeinsam vorgebbares Zeitintervall (Δt₀) zurück- oder vorverschoben wird.

3. Verfahren nach einem der vorangehenden Ansprüche, **dadurch gekennzeichnet, dass**
a) der Sollwert (aₛ) der asynchronen Zustandsvariablen (a(t)) global aus einem Mittelwert der Istwerte (aᵢ) einer Mehrzahl oder aller asynchroner Zustandsvariablen (a(t)) bestimmt wird oder
b) der Sollwert (aₛ) der asynchronen Zustandsvariablen (a(t)) lokal gewählt wird und insbesondere gleich einer Abweichung von einem stationären Wert der asynchronen Zustandsvariablen (a(t)) gewählt wird, welche Abweichung kleiner als 10% eines Erwartungswerts einer Maximalamplitude der asynchronen Zustandsvariablen (a(t)) ist und
c) insbesondere dass für einen Einschaltvorgang einer Reihenschaltung (4) oder für einen Ausschaltvorgang einer Parallelschaltung (1) ein DC-Anteil (a_{DC}) des Sollwerts (aₛ) und des Istwerts (aᵢ) der asynchronen Zustandsvariablen (a(t)) subtrahiert werden.

4. Verfahren nach einem der vorangehenden Ansprüche, **dadurch gekennzeichnet, dass**
a) zu zwei synchronen Abtastzeitpunkten (tsⱼ) Istwerte (aᵢ) gemessen werden und aus ihrem Gradienten (daᵢ/dt) und einem Gradienten-Sollwert (daₛ/dt) die Regelabweichung bestimmt wird,
b) eine Amplitude des Schaltsignals (i_{G1}, i_{G2}), für welches die Regelabweichung einem überhöhten oder erniedrigten Gradienten (daᵢ/dt) entspricht, im gleichen oder in einem der folgenden Schaltzyklen verringert oder erhöht wird und
c) insbesondere dass ein erster Abtastzeitpunkt in einem geringen Zeitabstand zu einem Bezugszeitpunkt (ts) des synchronen Ereignisses (eₛ) gewählt wird und eine Differenz zwischen den Abtastzeitpunkten (tsⱼ) durch einen zweiten Abtastzeitpunkt approximiert wird.

5. Verfahren zur dynamischen Symmetrisierung einer Schaltung (1, 4) von Leistungshalbleiterschaltern (S₁-S₄), wobei jeder Leistungshalbleiterschalter (S₁-S₄) einen ersten Leistungsanschluss oder Kollektor (C), einen zweiten Leistungsanschluss oder Emitter (E) und mindestens einen Steueranschluss oder ein Gate (G) umfasst, wobei dem Steueranschluss (G) ein Schaltbefehl (z) zur Initiierung eines Schaltvorgangs der Schaltung (1, 4) gegeben wird und der Steueranschluss (G) in Abhängigkeit von einer Regelabweichung einer Zustandsfunktion des Leistungshalbleiterschalters (S₁-S₄) durch ein individuelles Schaltsignal (i_{G1}, i_{G2}) ansteuerbar ist, **dadurch gekennzeichnet, dass**
a) die Zustandsfunktion gleich einer Zeitfunktion (t(a)) in Abhängigkeit einer asynchronen Zustandsvariablen (a) des Leistungshalbleiterschalters (S₁-S₄) gewählt wird, wobei für die asynchrone Zustandsvariable (a) mindestens ein den Leistungshalbleiterschaltern (S₁-S₄) gemeinsamer Schwellenwert (εₐ) global vorgegeben wird, für jeden Leistungshalbleiterschalter (S₁-S₄) bei Überschreiten des Schwellenwerts (εₐ) ein individueller Zeit-Istwert (taᵢ) gemessen wird,
b) durch ein synchrones Ereignis (eₛ) der Schaltung (1, 4) lokal ein Bezugszeitpunkt (ts) für den Zeit-Istwert (taᵢ) festgelegt wird und
c) im gleichen oder in einem der folgenden Schaltzyklen das Schaltsignal (i_{G1}, i_{G2}) zeitlich verschoben oder in der Amplitude variiert wird, so dass die Regelabweichung zwischen dem Zeit-Istwert (taᵢ) und einem vorgebbaren Zeit-Sollwert (taₛ) verringert wird.

6. Verfahren nach Anspruch 5, **dadurch gekennzeichnet, dass** der Zeit-Sollwert (taₛ) global aus einem Maximum der Zeit-Istwerte (taᵢ) bestimmt wird oder der Zeit-Sollwert (taₛ) lokal gewählt wird.

7. Verfahren nach einem der Ansprüche 5-6, **dadurch gekennzeichnet, dass** für jeden Leistungshalbleiterschalter (S₁-S₄)
a) die Regelabweichung aus einer Differenz zwischen dem Zeit-Istwert (taᵢ) und dem Zeit-Sollwert (taₛ) lokal bestimmt wird oder
b) der Bezugszeitpunkt (ts) nahe beim Zeit-Sollwert (taₛ) gewählt wird und die Regelabweichung durch den Zeit-Istwert (taᵢ) approximiert wird, und/oder
c) das Schaltsignal (i_{G1}, i_{G2}) initial verzögert und/oder seine Amplitude initial reduziert wird.

8. Verfahren nach einem der Ansprüche 5-7, **dadurch gekennzeichnet, dass**
a) bei zwei Schwellenwerten (εₐ) der asynchronen Zustandsvariablen (a(t)) Zeit-Istwerte (taᵢ) gemessen werden und aus ihrem Gradienten und einem Gradienten-Sollwert die Regelabweichung bestimmt wird und
b) eine Amplitude des Schaltsignals (i_{G1}, i_{G2}), für welches die Regelabweichung einem überhöhten oder erniedrigten Gradienten entspricht, im gleichen oder in einem folgenden Schaltzyklus verringert oder erhöht wird.

9. Verfahren nach einem der vorangehenden Ansprüche, **dadurch gekennzeichnet, dass**
a) als asynchrone Zustandsvariable (a(t)) bei einer Serieschaltung (4) eine Kollektor-Emitter oder Anoden-Kathoden Spannung (v_{CE3}(t), v_{CE4}(t)) oder ein Kollektor-Emitter oder Anoden-Kathoden Spannungsgradient oder bei einer Parallelschaltung (1) ein Kollektorstrom oder Anodenstrom (i_{C1}(t), i_{C2}(t)) oder ein Kollektorstromgradient oder Anodenstromgradient, gewählt wird und/oder
b) als eine synchrone Zustandsvariable (x(t)) bei einer Serieschaltung (4) ein Kollektorstrom oder Anodenstrom (i_{c}(t)) oder ein Kollektorstromgradient oder Anodenstromgradient oder bei einer Parallelschaltung (1) eine Kollektor-Emitter oder Anoden-Kathoden Spannung (v_{CE}(t)) oder ein Kollektor-Emitter oder Anoden-Kathoden Spannungsgradient gewählt wird.

10. Verfahren nach einem der vorangehenden Ansprüche, **dadurch gekennzeichnet, dass**
a) das synchrone Ereignis (eₛ) durch Überschreiten oder Überqueren oder Erreichen eines vorgebbaren Schwellenwerts (εₛ) einer synchronen Zustandsvariablen (x(t)) definiert wird oder
b) das synchrone Ereignis (eₛ) durch gegenläufige Amplitudenänderungen asynchroner Zustandsvariablen (a(t)) unterschiedlicher Leistungshalbleiterschalter (S₁-S₄) definiert wird,
c) insbesondere dass das synchrone Ereignis (eₛ) zu Beginn des Schaltvorgangs gewählt wird, indem eine Abweichung des Schwellenwerts (Es) von einem stationären Wert der synchronen Zustandsvariablen (x(t)) kleiner als 10% eines Erwartungswerts einer Maximalamplitude der synchronen Zustandsvariablen (x(t)) gewählt wird.

11. Verfahren nach einem der Ansprüche 1-9, **dadurch gekennzeichnet, dass**
a) für einen Ausschaltvorgang einer Parallelschaltung (1) das synchrone Ereignis (eₛ) näherungsweise **dadurch** definiert wird, dass in einer Phase A, in welcher eine in Serie zur Parallelschaltung (1) angeordnete Freilaufdiode (D_{S}) in einem leitfähigen Zustand ist, die asynchrone Zustandsvariable (a(t)) einen vorgebbaren Schwellenwert (εₐ") unterschreitet oder
b) für einen Einschaltvorgang einer Serieschaltung (4) das synchrone Ereignis (es₆') näherungsweise **dadurch** definiert wird, dass in einer Phase B, in welcher die Freilaufdiode (Dₛ) in einem Sperrzustand ist, die asynchrone Zustandsvariable (a(t)) einen vorgebbaren Schwellenwert (εₛ₆) unterschreitet oder
c) das synchrone Ereignis (eₛ) durch einen Wechsel zwischen einer Phase A, in welcher eine in Serie zur Schaltung (1, 4) angeordnete Freilaufdiode (D_{S}) in einem leitfähigen Zustand ist, und einer Phase B, in welcher die Freilaufdiode (D_{S}) in einem Sperrzustand ist, definiert wird.

12. Verfahren nach einem der vorangehenden Ansprüche, **dadurch gekennzeichnet, dass**
a) für einen Ausschaltvorgang einer Parallelschaltung (1) ein Bezugszeitpunkt (ts) des synchronen Ereignisses (eₛ) gleich einem Zeitpunkt gewählt wird, zu dem eine Kollektor-Emitter oder Anoden-Kathoden Spannung (v_{CE}(t)) einen Schwellenwert überschreitet und ein Kollektor-Emitter oder Anoden-Kathoden Spannungsgradient einen Schwellenwert, insbesondere den Schwellenwert Null, unterschreitet oder
b) für einen Einschaltvorgang einer Serieschaltung (4) ein Bezugszeitpunkt (ts) des synchronen Ereignisses (es) gleich einem Zeitpunkt gewählt wird, zu dem eine Kollektor-Emitter oder Anoden-Kathoden Spannung (v_{CE}(t)) einen Schwellenwert (Eₛ₆) unterschreitet, insbesondere dass der Schwellenwert (εₛ₆) kleiner als ein Erwartungswert der Kollektor-Emitter oder Anoden-Kathoden Spannung (v_{CE}(t)) am Ende einer Phase A gewählt wird, in welcher eine in Serie zur Reihenschaltung (4) angeordnete Freilaufdiode (Dₛ) in einem leitfähigen Zustand ist.

13. Verfahren nach einem der vorangehenden Ansprüche, **dadurch gekennzeichnet, dass**
a) das Schaltsignal (i_{G1}, i_{G2}), für welches die Regelabweichung einem Vorauseilen eines Istwerts (aᵢ) gegenüber einem Sollwert (aₛ) oder eines Zeit-Istwerts (taᵢ) gegenüber einem Zeit-Sollwert (taₛ) entspricht, zeitlich verzögert oder in der Amplitude reduziert wird oder
b) das Schaltsignal (i_{G1}, i_{G2}), für welches die Regelabweichung einem Nacheilen eines Istwerts (aᵢ) gegenüber einem Sollwert (aₛ) oder eines Zeit-Istwerts (taᵢ) gegenüber einem Zeit-Sollwert (taₛ) entspricht, zeitlich vorverschoben oder in der Amplitude erhöht wird und
c) insbesondere dass das Schaltsignal (i_{G1}, i_{G2}) ein Gatestrom (i_{G1}, i_{G2}), eine Gatespannung oder ein Zeitintegral des Gatestroms ist.

14. Verfahren nach einem der vorangehenden Ansprüche, **dadurch gekennzeichnet, dass** der Schaltbefehl (z) von einer zentralen Steuerung an mindestens einen ersten Leistungshalbleiterschalter (S₁) übertragen wird und
a) von dort an zweite Leistungshalbleiterschalter (S₂-S₄) lokale Einschaltbefehle erteilt werden und/oder
b) von zweiten Leistungshalbleiterschaltern (S₂-S₄) ein Schaltvorgang erkannt wird und aufgrund dessen, insbesondere durch Beobachtung von Änderungen synchroner und/oder asynchroner Zustandsvariablen (x(t), a(t)), lokale Schaltbefehle erzeugt werden.

15. Verfahren nach einem der vorangehenden Ansprüche, **dadurch gekennzeichnet, dass**
a) die Schaltung (1, 4) Bestandteil eines Schaltermoduls, insbesondere eines Halbbrückenzweigs eines Wechselrichters, für Traktion, Hochspannungsgleichstromübertragung, Radiosender, induktives Erwärmen oder induktives Schweissen ist und/oder
b) die Leistungshalbleiterschalter (S₁-S₄) BJTs, IGBTs, MOSFETs, Thyristoren, GTOs, MCTs oder Kombinationen solcher Bauelemente sind.

## Claims

1. Method for dynamically balancing a circuit (1, 4) of semiconductor power switches (S₁ - S₄), wherein each semiconductor power switch (S₁ -S₄) comprises a first power terminal or collector (C), a second power terminal or emitter (E) and at least one control terminal or gate (G), wherein a switching command (z) for initiating a switching process of the circuit (1, 4) is fed to the control terminal (G) and the control terminal (G) can be driven by means of an individual switching signal depending on a control loop offset of a state function of the semiconductor power switch (S₁ - S₄), **characterized in that**
a) the state function is a time-dependent asynchronous state variable (a(t)), an actual value (aᵢ) of which is measured at at least one synchronous sampling time (tsⱼ), wherein the synchronous sampling time (tsⱼ) is determined based on a synchronous event (eₛ) of the circuit (1, 4) for each semiconductor power switch individually, and
b) in the same or in one of the following switching cycles the switching signal (i_{G1}, i_{G2}) is offset in time or its amplitude is varied such that the control loop offset between the actual value (aᵢ) and a predefined desired value (aₛ) is reduced.

2. Method of claim 1, **characterized in that**
a) the synchronous sampling time (tsⱼ) is determined locally at each semiconductor power switch (S₁ - S₄), and/or
b) the synchronous sampling time (tsⱼ) is determined by shifting a reference time (ts) of the synchronous event (eₛ) back or forward in time by a time interval predefined in common for the semiconductor power switches (S₁ - S₄).

3. Method of any of the preceding claims **characterized in that**
a) the desired value (aₛ) of the asynchronous state variable (a(t)) is determined globally from an average value of the actual values (aᵢ) of a plurality or of all asynchronous state variables (a(t)), or
b) the desired value (aₛ) of the asynchronous state variable (a(t)) is chosen locally and in particular equal to an offset from the stationary value of the asynchronous state variable (a(t)), which offset is smaller than 10% of an expected value of a maximum amplitude of the asynchronous state variable (a(t)) and
c) in particular that for a switch-on process of a series circuit (4) or for the switch-off process of a parallel circuit (1) a DC component (a_{DC}) of the desired value (aₛ) and of the actual value (aᵢ) of the asynchronous state variable (a(t)) are subtracted.

4. Method of any of the preceding claims **characterized in that**
a) actual values (aᵢ) are measured at two synchronous sampling times (tsⱼ) and the control loop offset is determined from their gradient (daᵢ/dt) and a desired gradient value (daₛ/dt),
b) an amplitude of the switching signal (i_{G1}, i_{G2}), for which the control loop offset corresponds to a too high or to low gradient (daᵢ/dt), is increased or decreased in the same or in one of the next switching cycles, and
c) in particular that a first sample time is chosen at a small temporal distance to a reference time (ts) of the synchronous event (eₛ) and a difference between the sampling times (tsⱼ) is approximated by a second sampling time.

5. Method for dynamically balancing a circuit (1, 4) of semiconductor power switches (S₁ - S₄), wherein each semiconductor power switch (S₁ -S₄) comprises a first power terminal or collector (C), a second power terminal or emitter (E) and at least one control terminal or gate (G), wherein a switching command (z) for initiating a switching process of the circuit (1, 4) is fed to the control terminal (G) and the control terminal (G) can be driven by means of an individual switching signal (i_{G1}, i_{G2}) depending on a control loop offset of a state function of the semiconductor power switch (S₁ - S₄), **characterized in that**
a) the state function is chosen equal to a time function (t(a)) in dependence of an asynchronous state variable (a) of the semiconductor power switch (S₁ - S₄), wherein at least one threshold value (εₐ) common to the semiconductor power switches (S₁ - S₄) is globally provided for the asynchronous state variable (a), an individual actual time value (taᵢ) being measured for each semiconductor power switch (S₁ - S₄) upon exceeding the threshold value (εₐ),
b) a reference time (ts) for the actual time value (taᵢ) is locally defined by means of a synchronous event (eₛ) of the circuit (1, 4), and
c) in the same or one of the following switching cycles the switching signal (i_{G1}, i_{G2}) is offset in time or its amplitude is varied such that the control loop offset between the actual time value (taᵢ) and a predefined desired time value (taₛ) is reduced.

6. Method of claim 5 **characterized in that** the desired time value (taₛ) is determined globally from a maximum of the actual time values (taᵢ) or that the desired time value (taₛ) is chosen locally.

7. Method of one of the claims 5 to 6 **characterized in that** for each semiconductor power switch (S₁ - S₄)
a) the control loop offset is determined locally from a difference between the actual time value (taᵢ) and the desired time value (taₛ),
b) the reference time (ts) is chosen close to the desired time value (taₛ) and the control loop offset is approximated by means of the actual time value (taᵢ) and/or
c) the switching signal (i_{G1}, i_{G2}) is delayed initially and/or its amplitude is reduced initially.

8. Method of one of the claims 5 to 7 **characterized in that**
a) actual time values (taᵢ) are measured at two threshold values (εₐ) of the asynchronous state variable (a(t)) and that the control loop offset is determined from their gradient and from a desired gradient value, and
b) an amplitude of the switching signal (i_{G1}, i_{G2}) for which the control loop offset corresponds to a too high or too low gradient, is decreased or increased in the same or in a next switching cycle.

9. Method of any of the preceding claims **characterized in that**
a) for a serial circuit (4) a collector-emitter or an anode-cathode voltage (v_{CE3}(t), v_{CE4}(t)) or a collector-emitter or anode-cathode voltage gradient or for a parallel circuit (1) a collector current or anode current (i_{c1}(t), i_{c2}(t)) or a collector current gradient or an anode current gradient is chosen as asynchronous state variable (a(t)), and/or
b) for a series circuit (4) a collector current or an anode current (i_{c}(t)) or a collector current gradient or an anode current gradient or for a parallel circuit. (1) a collector-emitter or anode-cathode voltage (v_{CE}(t)) or a collector-emitter or anode-cathode voltage gradient is chosen as a synchronous state variable (x(t)).

10. Method of any of the preceding claims **characterized in that**
a) the synchronous event (eₛ) is defined by exceeding or crossing or reaching a given threshold value (εₛ) of a synchronous state variable (x(t)) or
b) the synchronous event (eₛ) is defined by opposite amplitude changes of asynchronous state variables (a(t)) of different semiconductor power switches (S₁ - S₄),
c) in particular that the synchronous event (eₛ) is chosen at the beginning of the switching process by choosing an offset of the threshold value (εₛ) from a stationary value of the synchronous state variable (x(t)) smaller than 10% of an expected value of a maximum amplitude of the synchronous state variable (x(t)).

11. Method of one of the claims 1 to 9 **characterized in that**
a) for a switch-off process of a parallel circuit (1) the synchronous event (eₛ) is defined approximately thereby that in a phase A, in which a free wheeling diode arranged in series to the parallel circuit (1) is in a conducting state, the asynchronous state variable (a(t)) falls below a given threshold value (εₐ") or
b) for a switch-on process of a series circuit (4) the synchronous event (es₆') is defined approximately thereby that in a phase B, in which the free wheeling diode (Dₛ) is in a blocking state, the asynchronous state variable (a(t)) falls below a given threshold value (εₛ₆), or
c) the synchronous event (eₛ) is defined by a change between a phase A, in which a free wheeling diode (Dₛ) arranged in series to the circuit (1, 4) is in a conducting state, and a phase B, in which the free wheeling diode (D_{S}) is in a blocking state.

12. Method of any of the preceding claims **characterized in that**
a) for a switch-off process of a parallel circuit (1) a reference time (ts) of the synchronous event (eₛ) is chosen to be equal to a time when a collector-emitter or anode-cathode voltage (v_{CE}(t)) exceeds a threshold value and a collector-emitter or anode-cathode voltage gradient falls below a threshold value, in particular a threshold value of zero, or
b) for the switch-on process of a series circuit (4) a reference time (ts) of the synchronous event (eₛ) is chosen to be equal to a time when a collector-emitter or anode-cathode voltage (v_{CE}(t)) falls below a threshold value (εₛ₆), in particular that the threshold value (εₛ₆) is chosen smaller than an expected value of the collector-emitter or anode-cathode voltage (v_{CE}(T)) at an end of a phase A, during which a free wheeling diode (D_{S}) arranged in series to the serial circuit (4) is in a conducting state.

13. Method of any of the preceding claims **characterized in that**
a) the switching signal (i_{G1}, i_{G2}) for which the control loop offset corresponds to a premature actual value (aᵢ) in relation to a desired value (aₛ) or to a premature actual time value (taᵢ) in relation to a desired time value (taₛ), is delayed time or reduced in amplitude or
b) the switching signal (i_{G1}, i_{G2}), for which the control loop offset corresponds to a late actual value (aᵢ) in relation to a desired value (aₛ) or to a late actual time value (taᵢ) in relation to a desired time value (taₛ), is offset to an earlier time or increased in amplitude and
c) in particular that the switching signal (i_{G1}, i_{G2}) is a gate current (i_{G1}, i_{G2}), a gate voltage or a time integral of the gate current.

14. Method of any of the preceding claims **characterized in that** the switching command (z) is transferred from a central control to at least one first semiconductor power switch (S₁) and
a) from there local switch-on commands are issued to second semiconductor power switches (S₂ - S₄) and/or
b) a switching process is detected by second semiconductor power switches (S₂ - S₄) and, as a consequence, in particular by observation of changes of synchronous or asynchronous state variables (x(t), a(t)), local switching commands are generated.

15. Method of any of the preceding claims, **characterized in that**
a) the circuit (1, 4) is part of a switching module, in particular a half bridge arm of an inverter, for traction, high voltage DC transmission, radio emitters, inductive heating or inductive welding and/or
b) the semiconductor power switches (S₁ - S₄) are BJTs, IGBTs, MOSFETs, thyristors, GTOs, MCTs or combinations of such devices.

## Revendications

1. Procédé d'équilibrage dynamique d'un circuit (1, 4) de commutateurs de puissance à semi-conducteurs (S₁-S₄) dans lequel chaque commutateur de puissance à semi-conducteurs (S₁-S₄) comprend une première connexion de puissance ou collecteur (C), une seconde connexion de puissance ou émetteur (E) et au moins une connexion de gâchette ou une grille (G), dans lequel un ordre de commutation (z) est donné à la connexion de gâchette (G) pour initier un processus de commutation du circuit (1, 4) et la connexion de puissance (G) peut être commandée par un signal de commutation individuel en fonction d'un écart de réglage d'une fonction d'état du commutateur de puissance à semi-conducteurs (S₁-S₄),
**caractérisé en ce que**
a) la fonction d'état est une variable d'état asynchrone dépendant du temps (a(t)) dont la valeur réelle (aᵢ) est mesurée à au moins un instant d'échantillonnage synchrone (tsⱼ), l'instant d'échantillonnage synchrone (tsⱼ) étant déterminé indépendamment pour chaque commutateur de puissance à semi-conducteurs (S₁-S₄) sur la base d'un événement synchrone (eₛ) du circuit (1, 4) et
b) le signal de commutation (i_{G1}, i_{G2}) est décalé dans le temps, ou son amplitude varie, pendant le même cycle de commutation ou pendant l'un des cycles de commutation suivants, de sorte l'écart de réglage entre la valeur réelle (aᵢ) et une valeur de consigne prédéfinissable (aₛ) est réduit.

2. Procédé selon la revendication 1, **caractérisé en ce que**
a) l'instant d'échantillonnage synchrone (tsⱼ) est déterminé localement au niveau de chaque commutateur de puissance à semi-conducteurs (S₁-S₄) et/ou
b) l'instant d'échantillonnage synchrone (tsⱼ) est déterminé en reculant ou en avançant un instant de référence (ts) de l'événement synchrone (eₛ) d'un intervalle de temps (Δt₀) prédéfinissable commun aux commutateurs de puissance à semi-conducteurs (S₁-S₄).

3. Procédé selon l'une quelconque des revendications précédentes, **caractérisé en ce que**
a) la valeur de consigne (aₛ) des variables d'état asynchrones (a(t)) est déterminée globalement à partir d'une valeur moyenne des valeurs réelles (aᵢ) d'une pluralité ou de toutes les variables d'état asynchrones (a(t)) ou
b) la valeur de consigne (aₛ) des variables d'état asynchrones (a(t)) est sélectionnée localement et, en particulier, est sélectionnée pour être égale à un écart par rapport à une valeur stationnaire des variables d'état asynchrones (a(t)), lequel écart est inférieur à 10% d'une valeur attendue d'une amplitude maximale des variables d'état asynchrones (a(t)) et
c) en particulier **en ce qu'**une composante de CC (a_{DC}) de la valeur de consigne (aₛ) et de la valeur réelle (aᵢ) des variables d'état asynchrones (a(t)) est soustraite pour un processus de mise en circuit d'un circuit en série (4) ou pour un processus de mise hors circuit d'un circuit en parallèle (1).

4. Procédé selon l'une quelconque des revendications précédentes, **caractérisé en ce que**
a) des valeurs réelles (aᵢ) sont mesurées à deux instants d'échantillonnage synchrones (tsⱼ) et l'écart de réglage est déterminé à partir de leur gradient (daᵢ/dt) et d'une valeur de consigne du gradient (daₛ/dt),
b) une amplitude du signal de commutation (i_{G1}, i_{G2}), pour lequel l'écart de réglage correspond à un gradient augmenté ou abaissé (daᵢ/dt), est diminuée ou augmentée pendant le même cycle de commutation ou pendant l'un des cycles de commutation suivants et
c) en particulier **en ce qu'**un premier instant d'échantillonnage est sélectionné dans un intervalle de temps réduit à un instant de référence (ts) de l'événement synchrone (eₛ) et une différence est approximée entre les instants d'échantillonnage (tsⱼ) au moyen d'un second instant d'échantillonnage.

5. Procédé d'équilibrage dynamique d'un circuit (1, 4) de commutateurs de puissance à semi-conducteurs (S₁-S₄) dans lequel chaque commutateur de puissance à semi-conducteurs (S₁-S₄) comprend une première connexion de puissance ou collecteur (C), une seconde connexion de puissance ou émetteur (E) et au moins une connexion de gâchette ou une grille (G), dans lequel un ordre de commutation (z) est donné à la connexion de gâchette (G) pour initier un processus de commutation du circuit (1, 4) et la connexion de puissance (G) peut être commandée par un signal de commutation individuel (i_{G1}, i_{G2}) en fonction d'un écart de réglage d'une fonction d'état du commutateur de puissance à semi-conducteurs (S₁-S₄), **caractérisé en ce que**
a) la fonction d'état est sélectionnée pour être égale à une fonction de temps (t(a)) dépendant d'une variable d'état asynchrone (a) du commutateur de puissance à semi-conducteurs (S₁-S₄), au moins une valeur de seuil (εₐ) commune aux commutateurs de puissance à semi-conducteurs (S₁-S₄) étant globalement prédéfinie pour la variable d'état asynchrone (a), une valeur réelle de temps individuelle (ta;) étant mesurée pour chaque commutateur de puissance à semi-conducteurs (S₁-S₄) en cas de dépassement de la valeur de seuil (εₐ),
b) un instant de référence (ts) pour la valeur réelle de temps (taᵢ) est fixé localement au moyen d'un événement synchrone (eₛ) du circuit (1, 4) et
c) le signal de commutation (i_{G1}, i_{G2}) est décalé dans le temps ou son amplitude varie pendant le même cycle de commutation ou pendant l'un des cycles de commutation suivants, de sorte l'écart de réglage entre la valeur réelle de temps (taᵢ) et une valeur de consigne de temps prédéfinissable (taₛ) est réduit.

6. Procédé selon la revendication 5, **caractérisé en ce que** la valeur de consigne de temps (taₛ) est déterminée globalement à partir d'un maximum des valeurs réelles de temps (taᵢ) ou la valeur de consigne de temps (taₛ) est sélectionnée localement.

7. Procédé selon l'une quelconque des revendications 5 ou 6, **caractérisé en ce que**, pour chaque commutateur de puissance à semi-conducteurs (S₁-S₄)
a) l'écart de réglage est déterminé localement à partir d'une différence entre la valeur réelle de temps (taᵢ) et la valeur de consigne de temps (taₛ) ou
b) l'instant de référence (ts) est sélectionné à proximité de la valeur consigne de temps (taₛ) et l'écart de réglage est approximé au moyen de la valeur réelle de temps (taᵢ) et/ou
c) le signal de commutation (i_{G1}, i_{G2}) est initialement retardé et/ou son amplitude est initialement réduite.

8. Procédé selon l'une quelconque des revendications 5 à 7, **caractérisé en ce que**
a) des valeurs réelles de temps (ta;) sont mesurées à deux valeurs de seuils (εₐ) des variables d'état asynchrones (a(t)) et l'écart de réglage est déterminé à partir de leur gradient et d'une valeur de consigne du gradient et
b) une amplitude du signal de commutation (i_{G1}, i_{G2}), pour lequel l'écart de réglage correspond à un gradient augmenté ou abaissé, est diminuée ou augmentée pendant le même cycle de commutation ou pendant un cycle de commutation suivant.

9. Procédé selon l'une quelconque des revendications précédentes, **caractérisé en ce que**
a) on sélectionne comme variable d'état asynchrone (a(t)) dans un circuit série (4) une tension collecteur-émetteur ou tension cathode-anode (v_{CE3} (t)), (v_{CE4} (t)) ou un gradient de tension collecteur-émetteur ou gradient de tension cathode-anode ou, dans un circuit parallèle (1), un courant de collecteur ou courant anodique (i_{C1} (t), (i_{C2} (t)) ou un gradient de courant de collecteur ou un gradient de courant anodique et/ou
b) on sélectionne comme variable d'état synchrone (x(t)) dans un circuit série (4) un courant de collecteur ou courant anodique (i_{c} (t)) ou un gradient de courant de collecteur ou gradient de courant anodique ou, dans un circuit parallèle (1), une tension collecteur-émetteur ou tension anode-cathode (v_{CE} (t)) ou un gradient de tension collecteur-émetteur ou gradient de tension anode-cathode.

10. Procédé selon l'une quelconque des revendications précédentes, **caractérisé en ce que**
a) l'événement synchrone (eₛ) est défini par le dépassement ou le franchissement ou l'atteinte d'une valeur de seuil prédéfinissable (εₛ) d'une variable d'état synchrone (x(t)) ou
b) l'événement synchrone (eₛ) est défini au moyen de variations d'amplitude opposées de variables d'état asynchrones (a(t)) de différents commutateurs de puissance à semi-conducteurs (S₁-S₄),
c) en particulier **en ce que** l'événement synchrone (eₛ) est sélectionné au début du processus de commutation, en sélectionnant un écart de la valeur seuil (εₛ) par rapport à une valeur stationnaire des variables d'état synchrones (x(t)) inférieur à 10% d'une valeur attendue d'une amplitude maximale des variables d'état synchrones (x(t)).

11. Procédé selon l'une quelconque des revendications 1 à 9, **caractérisé en ce que**
a) pour un processus de mise hors circuit d'un circuit parallèle (1), l'événement synchrone (eₛ) est défini approximativement **en ce que**, dans une phase A, dans laquelle une diode de roue libre (Dₛ) connectée en série par rapport au circuit parallèle (1) est dans un état conducteur, la variable d'état asynchrone (a(t)) devient inférieure à une valeur de seuil prédéfinissable (εₐ") ou
b) pour un processus de mise en circuit d'un circuit en série (4), l'événement synchrone (es₆') est défini approximativement **en ce que**, dans une phase B, dans laquelle la diode de roue libre (Dₛ) est dans un état bloqué, la variable d'état asynchrone (a(t)) devient inférieure à une valeur de seuil prédéfinissable (εₛ₆) ou
c) l'événement synchrone (eₛ) est défini par un changement entre une phase A, dans laquelle une diode de roue libre (Dₛ) connectée en série par rapport au circuit (1, 4) est dans un état conducteur, et une phase B, dans laquelle la diode de roue libre (Dₛ) est dans un état bloqué.

12. Procédé selon l'une quelconque des revendications précédentes, **caractérisé en ce que**
a) pour un processus de mise hors circuit d'un circuit parallèle (1), un instant de référence (ts) de l'événement synchrone (eₛ) est sélectionné pour être égal à un instant auquel une tension collecteur-émetteur ou tension anode-cathode (v_{CE} (t)) devient supérieure à une valeur de seuil et un gradient de tension collecteur-émetteur ou gradient de tension anode-cathode devient inférieur à une valeur de seuil, en particulier la valeur de seuil zéro, ou
b) pour un processus de mise en circuit d'un circuit série (4), un instant de référence (ts) de l'événement synchrone (eₛ) est sélectionné pour être égal à un instant auquel une tension collecteur-émetteur ou tension anode-cathode (v_{CE} (t)) devient inférieure à une valeur de seuil (εₛ₆), en particulier en ce que la valeur de seuil (εₛ₆) est sélectionnée pour être inférieure à une valeur attendue de la tension collecteur-émetteur ou tension anode-cathode (v_{CE} (t)) à la fin d'une phase A dans laquelle une diode de roue libre (Dₛ) connectée en série par rapport au circuit série (4) est dans un état conducteur.

13. Procédé selon l'une quelconque des revendications précédentes, **caractérisé en ce que**
a) le signal de commutation (i_{G1}, i_{G2}), pour lequel l'écart de réglage correspond à une avance de phase d'une valeur réelle (aᵢ) par rapport à une valeur de consigne (aₛ) ou d'une valeur réelle de temps (taᵢ) par rapport à une valeur de consigne de temps (taₛ), est retardé dans le temps ou son amplitude est réduite ou
b) le signal de commutation (i_{G1}, i_{G2}), pour lequel l'écart de réglage correspond à un retard de phase d'une valeur réelle (aᵢ) par rapport à une valeur de consigne (aₛ) ou d'une valeur réelle de temps (taᵢ) par rapport à une valeur de consigne de temps (taₛ), est avancé dans le temps ou son amplitude est augmentée et
c) en particulier **en ce que** le signal de commutation (i_{G1}, i_{G2}) est un courant de grille (i_{G1}, i_{G2}), une tension de grille ou une intégrale par rapport au temps du courant de grille.

14. Procédé selon l'une quelconque des revendications précédentes, **caractérisé en ce que** l'ordre de commutation (z) est transmis d'une commande centrale à au moins un premier commutateur de puissance à semi-conducteurs (S₁) et
a) de là, des ordres de commutation locaux sont transmis à des deuxièmes commutateurs de puissance à semi-conducteurs (S₂-S₄) et/ou
b) un processus de commutation est reconnu par les deuxièmes commutateurs de puissance à semi-conducteurs (S₂-S₄), sur la base duquel, en particulier par l'observation de variations de variables d'état synchrones et/ou asynchrones (x(t), a (t)), des ordres de commutation locaux sont générés.

15. Procédé selon l'une quelconque des revendications précédentes, **caractérisé en ce que**
a) le circuit (1, 4) fait partie d'un module de commutation, en particulier d'une branche d'un demi-pont d'un onduleur, pour la traction, la transmission d'une haute tension continue, un émetteur radio, un chauffage inductif ou un soudage inductif et/ou
b) les commutateurs de puissance à semi-conducteurs (S₁-S₄) sont des transistors à jonctions bipolaires (BJT), des transistors bipolaires à grille isolée (IGBT), des transistors à effet de champ à grille isolée (MOSFET), des thyristors, des thyristors à gâchette de blocage (GTO), des thyristors MOS commandés (MCT) ou des combinaisons de tels composants.
